Europäisches Patentamt

European Patent Office

Office européen des brevets

(11) Veröffentlichungsnummer: **0 180 782**
**A1**

# EUROPÄISCHE PATENTANMELDUNG

(21) Anmeldenummer: **85112624.3**

(22) Anmeldetag: **04.10.85**

(51) Int. Cl.⁴: **H 01 R 13/631**

(30) Priorität: **31.10.84 DE 3439836**

(43) Veröffentlichungstag der Anmeldung:
**14.05.86 Patentblatt 86/20**

(84) Benannte Vertragsstaaten:
**CH DE FR GB IT LI SE**

(71) Anmelder: **Siemens Aktiengesellschaft**
**Berlin und München Wittelsbacherplatz 2**
**D-8000 München 2(DE)**

(72) Erfinder: **Glomb, Kurt, Dipl.-Ing. (FH)**
**Nelkenstrasse 11**
**D-8034 Germering(DE)**

(72) Erfinder: **Niggl, Heinz, Ing. grad.**
**Lindenberg 149**
**D-8134 Pöcking(DE)**

(72) Erfinder: **Pelzl, Leo, Dipl.-Ing. (FH)**
**Alpenblickstrasse 5**
**D-8150 Holzkirchen(DE)**

(72) Erfinder: **Zell, Karl, Dipl.-Ing. (FH)**
**Moritz-von-Schwind-Weg 80**
**D-8134 Niederpöcking(DE)**

(54) **Vielpolige Steckverbinderleiste.**

(57) Zum Ausrichten der einzelnen Anschlußelemente (2) einer vielpoligen Steckverbinderleiste ist auf die freien Enden der Anschlußelemente (2) eine Folie (1) mit Öffnungen (3) für die Anschlußelemente (2) aufgesteckt, wobei die Anordnung der Öffnungen (3) der Folie (1) der Anordnung der Bohrungen auf der Leiterplatte entspricht.

Siemens Aktiengesellschaft      -1-

Vielpolige Steckverbinderleiste

Die Erfindung betrifft eine vielpolige Steckverbinderleiste mit freistehenden Anschlußelementen zum Einpressen in Bohrungen einer Leiterplatte.

Von derartigen vielpoligen Steckverbinderleisten wird gefordert, daß sie einfach und schnell gesteckt werden können. Dabei kommt es darauf an, daß alle Anschlußelemente der Steckverbinderleiste genau in die Bohrungen der Leiterplatte treffen. In dieser Hinsicht treten erhebliche Probleme auf bei eng beieinanderliegenden Anschlußelementen, die freistehen und eine verhältnismäßig große Länge aufweisen bzw. abgewinkelt sind.

Aufgabe der vorliegenden Erfindung ist es, eine vielpolige Steckverbinderleiste anzugeben, bei welcher die Anschlußelemente an ihren Enden exakt ausgerichtet sind.

Diese Aufgabe wird für eine vielpolige Steckverbinderleiste der eingangs genannten Art erfindungsgemäß dadurch gelöst, daß auf die freien Enden der Anschlußelemente eine Folie mit Öffnungen für die einzelnen Anschlußelemente aufgesteckt ist, wobei die Anordnung der Öffnungen der Folie der Anordnung der Bohrungen auf der Leiterplatte entspricht.

Durch die auf die freien Enden der Anschlußelemente aufgesteckte Folie wird eine exakte Ausrichtung jedes einzelnen Anschlußelementes erreicht. Dadurch ist sichergestellt, daß jedes Anschlußelement beim Stecken der Steck-

Som 1 Sur / 31.10.1984

verbinderleiste die entsprechende Bohrung der Leiterplatte trifft.

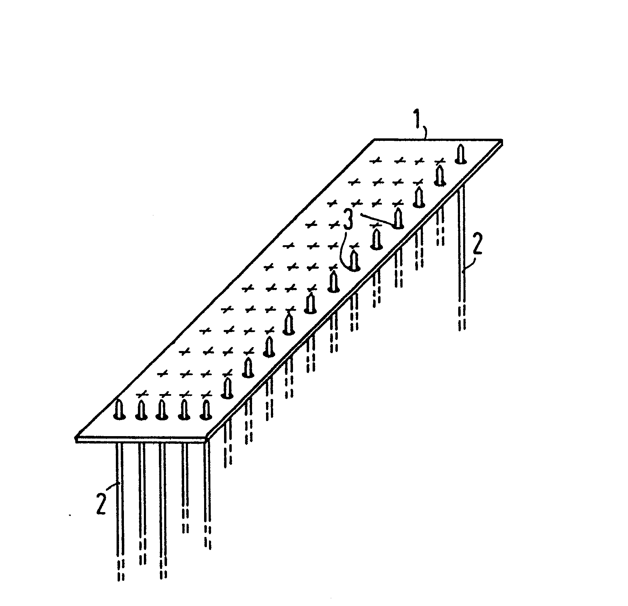

Nachfolgend wird die Erfindung anhand eines in der Zeichnung dargestellten Ausführungsbeispieles beschrieben.

In der Zeichnung sind einzelne von vielen Anschlußelementen 2 einer Steckverbinderleiste dargestellt. Auf die
Darstellung der eigentlichen Steckverbinderleiste wurde
in diesem Zusammenhang verzichtet, da unterschiedlichste
Ausgestaltungen möglich sind, wobei diese nicht erfindungswesentlich sind. Es wird jedoch davon ausgegangen,
daß es sich bei der vielpoligen Steckverbinderleiste um
eine Leiste handelt, die viele freistehende, eng beieinanderliegende Anschlußelemente aufweist, wobei die einzelnen Anschlußelemente eine verhältnismäßig große Länge
aufweisen. Es ist auch denkbar, daß die einzelnen Anschlußelemente 2 bei einer großen Länge zusätzlich noch
abgebogen sein können. Davon ausgehend, sind die Schwierigkeiten beim Stecken einer derartigen Steckverbinderleiste offensichtlich, da eine exakte Ausrichtung der
einzelnen Anschlußelemente 2 fast nicht gegeben ist.

Diese Schwierigkeiten werden nun bei der erfindungsgemäßen Steckverbinderleiste dadurch vermieden, daß auf die
freien Enden der Anschlußelemente vor dem Steck- und Einpreßvorgang eine Folie 1 aufgesteckt wird. Diese Folie
besitzt Öffnungen 3 für die Anschlußelemente 2, wobei die
Verteilung der Öffnungen 3 in der Folie 1 der Verteilung
der Bohrungen auf der Leiterplatte entsprechen. Da die
Folie biegsam ist, ist der eigentliche Aufsteckvorgang
der Folie 1 auf die Anschlußelemente 2, solange diese
frei zugänglich sind, einfach zu handhaben. Nach dem Aufstecken, wenn die Folie also in einer Ebene ausgerichtet
ist, besitzt sie eine derartige Steifheit, daß die Lage der Anschlußelemente 2 exakt fixiert ist. Während des eigentlichen Einpreßvorgangs, d.h. nach dem Einführen der freien Enden der Anschlußelemente 2 in die Bohrungen der Leiterplatte, liegt die Folie 1 auf der Leiterplatte auf.

1 Patentanspruch
1 Figur

Patentanspruch

Vielpolige Steckverbinderleiste mit freistehenden Anschlußelementen zum Einpressen in Bohrungen einer Leiterplatte, d a d u r c h   g e k e n n z e i c h n e t , daß auf die freien Enden der Anschlußelemente (2) eine Folie (1) mit Öffnungen (3) für die einzelnen Anschlußelemente (2) aufgesteckt ist, wobei die Anordnung der Öffnungen (3) der Folie (1) der Anordnung der Bohrungen auf der Leiterplatte entspricht.

0180782

0180782

Nummer der Anmeldung

**EUROPÄISCHER RECHERCHENBERICHT**

Europäisches
Patentamt

EP 85 11 2624

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | IBM TECHNICAL DISCLOSURE BULLETIN, Band 26, Nr. 1, Juni 1983, Seite 218, New York, US; M. APGAR et al.: "Connector aligner aid" * Insgesamt * ----- | 1 | H 01 R 13/631 |
| | | | **RECHERCHIERTE SACHGEBIETE (Int Cl 4)** H 01 R |

Der vorliegende Recherchenbericht wurde für alle Patentansprüche erstellt

| Recherchort DEN HAAG | Abschlußdatum der Recherche 20-01-1986 | Prüfer RIEUTORT A.S. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82